# EUROPEAN PATENT SPECIFICATION

(11) **EP 2 132 969 B1**
(45) Date of publication and mention of the grant of the patent: **23.05.2012**
(21) Application number: 08741101.3
(22) Date of filing: 02.04.2008
(51) Int. Cl.: H05K 9/00

(54) **ELECTROMAGNETIC INTERFERENCE SHIELD GLASS WITH BLACKENED CONDUCTIVE PATTERN AND METHOD OF PRODUCING THE SAME**
ABSCHIRMUNGSGLAS FÜR ELEKTROMAGNETISCHE INTERFERENZ MIT SCHWARZER LEITFÄHIGER STRUKTUR UND HERSTELLUNGSVERFAHREN DAFÜR
BLINDAGE CONTRE LES INTERFÉRENCES ÉLECTROMAGNÉTIQUES COMPRENANT UN RÉSEAU CONDUCTEUR NOIRCI ET PROCÉDÉ DE PRODUCTION DE CELUI-CI

(30) Priority: 02.04.2007 KR 20070032218
(43) Date of publication of application: 16.12.2009
(73) Proprietor: LG Chem, Ltd., Youngdungpo-gu, Seoul 150-721 (KR)
(72) Inventor: LEE, Dong-Wook, Daejeon Metropolitan City 305-729 (KR); CHUN, Sang-Ki, Yuseong-gu, Daejeon, 305-380 (KR); KIM, Seung-Wook, Yongin-si Gyeonggi-do 446-913 (KR); HWANG, In-Seok, Daejeon Metropolitan City 305-340 (KR)
(74) Representative: Goddar, Heinz J.
(86) International application number: PCT/KR2008/001851
(87) International publication number: WO 2008/120951

(56) References cited:
- EP-A2- 1 239 717
- WO-A1-2007/069870
- JP-A- 2002 057 490
- JP-A- 2002 271 086
- KR-A- 20040 085 762

## Description

### Technical Field

The present invention relates to a method of producing an electromagnetic interference shield glass wherein low specific resistance is maintained in order to sufficiently show an electromagnetic interference shield function and contrast of a display device is not affected due to blackening treatment, and an electromagnetic interference shield glass that is produced by using the same.

This application claims priority from Korea Patent Application No. 10-2007-32218 filed on April 2, 2007 in the KIPO.

### Background Art

In general, a display device means TVs or monitors for computers, and comprises a display assembly that has a display panel for forming an image and a casing that supports the display assembly.

The display assembly comprises a display panel such as a CRT (Cathode Ray Tube), an LCD (Liquid Crystal Display), and a PDP (Plasma display Panel) to form an image, a driving circuit substrate to drive the display panel, and an optical filter that is disposed at a front side of the display panel.

The optical filter comprises an anti-reflection film that prevents external light incident from the outside from being reflected again, a near infrared ray shielding film that shields the near infrared ray generated from the display panel in order to prevent a malfunction of an electronic device such as a remote control, a color correction film that comprises a color control dye to control the color tone so that the color purity is increased, and an electromagnetic interference shield film that shields an electromagnetic wave generated from the display panel during the driving of the display device.

In connection with this, the electromagnetic interference shield film comprises a film that is made of a transparent material and a conductive mesh pattern that is made of a metal material having the excellent electric conductivity such as silver, copper and the like and is formed on the film.

In the related art, in order to shield the harmful electromagnetic wave from the PDP. a mesh pattern that is made of a copper material is manufactured by using a photolithography process. However, since the photolithography process is complicated, the production cost is increased and is most costly in respects to raw material of the PDP filter. Accordingly, in order to raise the competitive power in respects to LCDs, it is required to develop a low-priced raw material, and a technology has been developed to print a mesh pattern by using a conductive paste through a printing process.

Among them, a screen printing process as an early technology is disadvantageous in that since it is impossible to print a fine pattern with a width of 50 µm or less, visibility of an image is poor. On the other hand, in the case of an offset printing process, since it is possible to uniformly print a relatively fine pattern, the possibility of the offset printing process has been mentioned as a method of producing an electromagnetic interference shield film for PDP filters.

EP 1 239 717 A1 discloses a method of producing an electromagnetic shielding plate having a glass substrate and a geometric pattern formed on the substrate wherein the geometric pattern is blackened by firing.

There is a need to develop a material used to sufficiently realize the characteristics of the electromagnetic interference shield film that is manufactured by the offset printing process.

In order to achieve this, the use of the conductive paste comprising the metal powder has been developed. However, in the case of when the offset printing process is performed by using the conductive paste, light from the PDP and external light is reflected due to a gloss of metal, which negatively affects contrast. Therefore, there is a need to perform blackening treatment.

### Disclosure of Invention

### Technical Problem

It is an object of the present invention to provide a method of producing an electromagnetic interference shield glass that can reduce surface resistance while a conductive pattern is sufficiently blackened, and an electromagnetic interference shield glass that is produced by using the same.

It is another object of the present invention to provide a PDP filter that is produced by additionally attaching an anti-reflection film, a near infrared ray shielding film, a color correction film or the like to a blackened electromagnetic interference shield glass, and a PDP device comprising the same.

### Technical Solution

In order to accomplish the above objects, the present invention provides a method of producing an electromagnetic interference shield glass in which an interface between a conductive pattern and a glass substrate is blackened through a firing process to fix the conductive pattern without a separate blackening treatment process and an increase in surface resistance, and a blackened electromagnetic interference shield glass.

That is, a film type of electromagnetic interference shield unit is not used and an electromagnetic interference shield unit is directly formed on a surface of glass to simplify a structure or a production process. In particular, a firing process is sufficiently performed while a firing temperature is freely controlled without the limit of the firing temperature. Thus, it is possible to provide a blackened electromagnetic interference shield glass that comprises the electromagnetic interference shield unit having the optimum conductivity, and a method of producing the same.

### Advantageous Effects

According to the present invention, a film type of electromagnetic interference shield layer is not used and a conductive pattern is directly formed on a surface of glass by using a printing process to simplify a structure of an electromagnetic interference shield glass and a structure of a display device comprising the same.

That is, since a process of separately producing and attaching the film type of electromagnetic interference shield unit is omitted, the production cost is reduced, and a total process is simplified.

In addition, a conductive paste is directly printed on the surface of glass and a firing process is sufficiently performed while a firing temperature is freely controlled without the limit of the firing temperature of the conductive paste. Thus, it is possible to improve shielding efficiency by using the electromagnetic interference shield unit having the optimum conductivity.

Additionally, it is possible to provide an electromagnetic interference shield glass that can prevent dazzling due to a luster of metal through a blackening process after the firing process without an increase in surface resistance.

### Best Mode for Carrying Out the Invention

An embodiment of the present invention provides a method of producing a blackened electromagnetic interference shield glass. The method comprises (a) forming a conductive pattern on at least one side of a front side and a rear side of glass, (b) firing the conductive pattern that is formed on the surface of the glass, and (c) blackening a surface of the conductive pattern by using a solution comprising a reductive metal ion.

In said (a) forming of the conductive pattern, the conductive pattern may be directly formed on the surface of the glass by using a conductive paste through a printing process.

The type of conductive paste is not limited, but the conductive paste may comprise one or more metal powders selected from the group consisting of copper, silver, gold, and aluminum, a polymer binder, and a glass frit that is used to improve an adhesion strength between a paste and a glass substrate. It is preferable to use the conductive paste that comprises a silver (Ag) component having excellent electric conductivity and low specific resistance as a metal component.

The conductive paste may be prepared, for example, by adding the metal powder, the glass frit, and, if necessary, an additive, after the polymer binder is dissolved in the organic solvent, mixing them with each other, and uniformly dispersing the metal powder and the glass frit while a pulverizing process is performed by using a three-stage roll mill.

It is required that the organic solvent can prevent a reduction in printability according to a printing process, in particular, swelling of a blanket by the organic solvent during an offset printing process. It is preferable to use butyl carbitol acetate, carbitol acetate, cyclohexanone, cellosolve acetate, terpineol or the like.

It is preferable that the conductive paste comprise 60 to 80 wt% of metal powder, 5 to 20 wt% of organic solvent, 5 to 20 wt% of polymer binder, and 5 to 15 wt% of glass frit. In the case of the firing, since the glass frit is moved toward the glass substrate side to improve the adhesion strength between the glass substrate and the conductive pattern, it is required that the glass frit can be melted at a softening temperature of glass or less to move toward the glass substrate. It is preferable that in the case of the glass frit with the softening temperature of about 400°C, since the softening tem perature is lower than the melting point of the metal powder, the glass frit is first melted and then moved toward the glass substrate side to have a predetermined adhesion strength.

A method of printing the conductive pattern on the surface of the glass may be selected from the group consisting of an offset printing process, a screen printing process, a gravure printing process, and an inkjet printing process, but is not limited thereto. Any printing process that is known in the art may be used as long as printing can be directly performed on the surface of the glass.

In connection with this, the offset printing process comprises filling a concave part of a flat plate that comprises concave and convex parts with the conductive paste; bringing the flat plate into contact with a printing blanket to transfer the conductive paste from the concave part of the flat plate to the printing blanket; and bringing the printing blanket into contact with a surface of a glass to transfer the conductive paste from the printing blanket to the surface of the glass to form the conductive pattern on the surface of the glass. In connection with this, the conductive paste may be transferred onto the surface of the glass by using the convex part instead of the concave part according to a typical offset printing process.

If the conductive pattern is fired at 400 to 700°C after the conductive pattern is formed on the glass substrate, the glass frit that is uniformly added to the paste is melted at a predetermined temperature or more, moved toward the glass substrate, and fused to improve the adhesion strength between the conductive paste and the glass substrate. In the case of when the firing temperature is less than 400°C, the temperature is reduced to be lower than the softening point of the glass frit, causing a reduction in the adhesion strength. In the case of when the firing temperature is more than 700°C, a distortion point is formed according to the bending or the surface unevenness of the glass. Thus, it is difficult to use the paste for displays.

In addition, the glass substrate on which the conductive pattern is formed is fired at preferably in the range of 500 to 650°C and more preferably in the range of 600 to 650°C so as to satisfy the condition of the tempered glass.

The firing time may be reduced as the firing temperature is increased, and in the range of about 3 to 30 min and preferably in the range of about 3 to 10 min in consideration of the productivity.

If the printing is performed by using the printing process such as the offset printing process by means of the conductive paste, a fine pattern having a width of 20 µm or less may be formed. However, light on the PDP or external light is reflected due to a gloss of metal such as silver, which negatively affects the contrast. Thus, in order to avoid this, it is required to perform the blackening treatment.

The blackening treatment may be performed by using the solution comprising the reductive metal ion.

The reductive metal ion means a metal ion that receives electrons from the conductive pattern when the ion comes into contact with the conductive pattern in the present invention to reduce the oxidation number. The reductive metal ion is not limited as long as the reductive metal ion can satisfy the blackening of the surface of the conductive pattern.

Examples of the reductive metal ion may comprise Fe or Cu ions, and examples of the solvent of the solution comprising the reductive metal ion may comprise water or the like.

The solution that comprises the reductive metal ion may further comprise a Cl ion in addition to the reductive metal ion.

In the case of when the solution comprising the reductive metal ion further comprises the Cl ion, if the conductive pattern is dipped in the solution that comprises the Cl ion and the reductive metal ion, a crystal growth phenomenon occurs due to the Cl ion. Thus, a chlorine salt (Cl salt) crystal is formed on the surface of the conductive pattern.

As described above, if the chlorine salt crystal is formed on the surface of the conductive pattern, the surface resistance (Ω/□) of the conductive pattern is reduced and the conductivity is improved.

Specifically, the solution comprising the reductive metal ion may be selected from the group consisting of a FeCl₂ solution, a FeCl₃ solution, a CuCl₂ solution, a K₃ Fe(CN)₆ solution, and the K₃Fe(CN)₆ solution to which the solution comprising the Cl ion is added.

The FeCl₃ solution may comprise 0.01 to 50 wt% of FeCl₃ based on the total weight and water as the remains so that the total weight is 100 wt%.

The CuCl₂ solution may comprise 0.01 to 50 wt% of CuCl₂ based on the total weight and water as the remains so that the total weight is 100 wt%.

The K₃Fe(CN)₆ solution may comprise 0.01 to 50 wt% by weight of K₃Fe(CN)₆ based on the total weight and water as the remains so that the total weight is 100 wt%.

In the case of when the solution comprising the Cl ion is added to the K₃Fe(CN)₆ solution, the K₃Fe(CN)₆ solution may comprise 0.01 to 50 wt% of K₃Fe(CN)₆ based on the total weight, 0.01 to 50 wt% of the solution comprising the Cl ion based on the total weight, and water as the remains so that the total weight is 100 wt%. In connection with this, the solution comprising the Cl ion that is added to the K₃Fe(CN)₆ solution is preferably HCl, but is not limited thereto.

The reductive metal ion and the solution comprising the Cl ion are not limited to the above examples. Various types of other solutions that comprise Cl ions used to form a Cl salt crystal on the surface of the conductive pattern and reductive metal ions used to oxidize the surface of the conductive pattern may be used.

The blackening treatment may be performed by using a batch process in which the glass on which the conductive pattern is printed is dipped in a blackening bath containing the solution comprising the reductive metal ion for 3 to 300 sec.

The method of producing the conductive pattern according to the present invention may further comprise washing the conductive pattern that is blackened during the blackening treatment; and drying the conductive pattern that is washed during the washing step.

In the drying, the conductive pattern may be dried at the temperature in the range of 50 to 120°C for 3 to 10 min.

Another embodiment of the present invention provides an electromagnetic interference shield glass that comprises a glass, and a conductive pattern that is formed on at least one side of a front side and a rear side of the glass wherein a surface of the conductive pattern is blackened by using a solution comprising a reductive metal ion.

Still another embodiment of the present invention provides a PDP filter that comprises the electromagnetic interference shield glass, and at least one film that is selected from the group consisting of an anti-reflection film, a near infrared ray shielding film, and a color correction film.

In addition, a further embodiment of the present invention provides a PDP device that comprises the PDP filter.

### Mode for the Invention

A better understanding of the present invention may be obtained in light of the following Examples which are set forth to illustrate, but are not to be construed to limit the present invention.

EXAMPLE: Production of the blackened electromagnetic interference shield glass

(1) Preparation of the conductive paste

Ethyl cellulose (TCI products) that was the polymer binder was dissolved in butyl carbitol acetate so that the total weight of the polymer binder and the organic solvent was 10 wt% to prepare an organic binder resin solution. The weight of the organic binder resin solution was 20 wt% based on the total weight of the paste. Silver powder having the purity of 99.99% (HAG-050S manufactured by Changsung Corp.) was added to the organic binder resin solution in an amount of 75 wt% based on the total weight of the paste, the glass frit (G3-3889 manufactured by Okuno, Co., Ltd.) was added to the organic binder resin solution in an amount of 5 wt% based on the total weight of the paste, and the sufficient mixing was performed. Next, the agglomerated silver powder and glass frit were uniformly dispersed by using a three-stage roll mill, and it was confirmed that the paste dispersed by using the roll mill had the shape. Subsequently, the resulting paste was recovered.

(2) Printing and firing of the conductive pattern

The conductive paste that was prepared by using the above method was applied on the glass substrate by using the offset printing process to form the conductive pattern, fired at 600°C for 10 min, and cooled to normal temperature to produce the glass having the conductive pattern.

(3) Blackening treatment of the conductive pattern

FeCl₃ (16019-02 manufactured by Kanto Chemical, Co., Ltd.) that was the compound comprising the reductive metal ion was added to distilled water in an amount of 1 wt% based on the reductive solution, and sufficiently agitated. The glass having the conductive pattern was dipped in the prepared blackened solution for 1 min to blacken the conductive pattern.

(4) Evaluation of the electromagnetic interference shield glass

In respects to the products that were produced in Examples, the surface resistance and the blackening degree were evaluated. In respects to the surface resistance, the surface resistance of the surface of the pattern that was printed by using the 4-probe method was measured by using a low resistance measuring device. The blackening degree of the printed glass was converted into the blackening degree value (L) after the reflectance of the printed glass was measured by using the spectrophotometer, and the results are described in Table 1. In connection with this, the color of paste approaches the black as the blackening degree value (L) is reduced.

COMPARATIVE EXAMPLE 1: Production of the electromagnetic interference shield glass not subjected to the blackening treatment

The electromagnetic interference shield glass was produced by using the same composition and method as Example, except that the conductive pattern formed on the surface of the glass was not subjected to the blackening treatment, and the surface resistance and the blackening degree were measured. The results are described in Table 1.

COMPARATIVE EXAMPLE 2: Production of the electromagnetic interference shield glass subjected to the blackening treatment by using metal oxide

The mixture of metal oxide comprising manganese oxide, iron oxide, copper oxide and the like was added to the conductive paste according to Example as the blackening treatment substance in a content of 5 wt% to prepare the conductive paste. The conductive pattern was formed by using the prepared conductive paste according to the same printing process as that of Example, and then fired to produce the electromagnetic interference shield glass without a separate blackening step. In respects to the produced electromagnetic interference shield glass, the surface resistance and the blackening degree were measured by using the same method as Example, and the results are described in Table 1.

COMPARATIVE EXAMPLE 3: Production of the electromagnetic interference shield glass subjected to the blackening treatment by using carbon black

In addition to the composition of Example, carbon black was added as an additional blackening treatment substance in a content of 25 wt% to prepare the conductive paste. The conductive pattern was formed by using the prepared conductive paste according to the same printing process as that of Example, and then fired to produce the electromagnetic interference shield glass without a separate blackening step. In respects to the produced electromagnetic interference shield glass, the surface resistance and the blackening degree were measured by using the same method as Example, and the results are described in Table 1.

Table 1
[Table 1]

**[Table]**

| Surface resistance and blackening degree of the electromagnetic interference shield glass produced in Example and Comparative Examples | | |
|---|---|---|
| | Surface resistance (Ω/□) | Blackening degree (L value) |
| Example | 0.12 | 28.9 |
| Comparative Example 1 | 0.12 | 48.8 |
| Comparative Example 2 | 0.56 | 29.2 |
| Comparative Example 3 | 1.82 | 35.4 |

As shown in Table 1, in the case of Comparative Example 1 in which the production was performed by using the same procedure as Example except for the blackening treatment step, the surface resistance was the same but the blackening degree was very high, thus reducing the contrast of the PDP due to a gloss of metal. In the case of Comparative Example 2 in which the metal oxide was mixed with the conductive paste and subjected to blackening treatment instead of performing the blackening treatment by the solution comprising the reductive metal ion, the blackening degree was excellent and similar to the value of the electromagnetic interference shield glass according to Example. However, since the surface resistance was rapidly increased, there was a problem in realization of the performance of the electromagnetic interference shield. In addition, in the case of Comparative Example 3 in which carbon black was used instead of the metal oxide of Comparative Example 2, even through the addition amount was increased to the amount of 25 wt% of the conductive paste, the blackening degree was not excellent in comparison with Example, and in particular, since the surface resistance was increased about 10 times, in views of the performance of the electromagnetic interference shield, the case was very disadvantageous.

## Claims

1. A method of producing a blackened electromagnetic interference shield glass, the method comprising:
(a) forming a conductive pattern on at least one side of a front side and a rear side of glass;
(b) firing the conductive pattern that is formed on the surface of the glass; and
(c) blackening a surface of the conductive pattern by using a solution comprising a reductive metal ion.

2. The method of producing a blackened electromagnetic interference shield glass as set forth in claim 1, wherein in said (a) forming of the conductive pattern, the conductive pattern is formed on the surface of the glass by using a conductive paste through a printing process.

3. The method of producing a blackened electromagnetic interference shield glass as set forth in claim 2, wherein the conductive paste is prepared by dispersing a polymer binder, a glass frit and one or more metal powders selected from the group consisting of silver, copper, gold, and aluminum in an organic solvent.

4. The method of producing a blackened electromagnetic interference shield glass as set forth in claim 2, wherein the conductive paste comprises 60 to 80 wt% of metal powder, 5 to 15 wt% of glass frit, 5 to 20 wt% of polymer binder, and 5 to 20 wt% of organic solvent.

5. The method of producing an electromagnetic interference shield glass as set forth in claim 1, wherein the firing is performed at 400 to 700°C.

6. The method of producing a blackened electromagnetic interference shield glass as set forth in claim 1, wherein the solution comprising the reductive metal ion is selected from the group consisting of a FeCl₂ solution, a FeCl₃ solution, a CuCl₂ solution, and a K₃Fe(CN)₆ solution.

7. The method of producing a blackened electromagnetic interference shield glass as set forth in claim 1, wherein the solution comprising the reductive metal ion further comprises a Cl ion.

8. An electromagnetic interference shield glass comprising:
a glass; and
a conductive pattern that is formed on at least one side of a front side and a rear side of the glass,
wherein the conductive pattern that is formed on the surface of the glass is fixed, and
wherein a surface of the conductive pattern is blackened by using a solution comprising a reductive metal ion.

9. The electromagnetic interference shield glass as set forth in claim 8, wherein the conductive pattern is formed on the surface of the glass by using a conductive paste through a printing method.

10. The electromagnetic interference shield glass as set forth in claim 9, wherein the conductive paste is prepared by dispersing a polymer binder, a glass frit and one or more metal powders selected from the group consisting of silver, copper, gold and aluminum in an organic solvent.

11. The electromagnetic interference shield glass as set forth in claim 9, wherein the conductive paste comprises 60 to 80 wt% of metal powder, 5 to 15 wt% of glass frit, 5 to 20 wt% of polymer binder, and 5 to 20 wt% of organic solvent.

12. The electromagnetic interference shield glass as set forth in claim 8, wherein the glass having the conductive pattern is fired at 400 to 700°C before the blackening.

13. The electromagnetic interference shield glass as set forth in claim 8, wherein the solution comprising the reductive metal ion is selected from the group consisting of a FeCl₂ solution, a FeCl₃ solution, a CuCl₂ solution, and a K₃Fe(CN)₆ solution.

14. The electromagnetic interference shield glass as set forth in claim 8, wherein the solution comprising the reductive metal ion further comprises a Cl ion.

15. A PDP filter comprising:
the electromagnetic interference shield glass according to claim 8; and
at least one film that is attached to a front side or a rear side of the electromagnetic interference shield glass and is selected from the group consisting of an anti-reflection film, a near infrared ray shielding film, and a color correction film.

16. A PDP device comprising the PDP filter according to claim 15.

## Patentansprüche

1. Verfahren zur Herstellung eines geschwärzten Abschirmungsglases für elektromagnetische Interferenz, wobei das Verfahren umfasst:
(a) Ausbilden einer leitfähigen Struktur auf wenigstens einer Seite von einer Vorderseite und einer Rückseite des Glases;
(b) Brennen der leitfähigen Struktur, die auf der Oberfläche des Glases ausgebildet ist; und
(c) Schwärzen einer Oberfläche der leitfähigen Struktur durch Verwendung einer Lösung, die ein reduktives Metall-Ion umfasst.

2. Verfahren zur Herstellung eines geschwärzten Abschirmungsglases für elektromagnetische Interferenz nach Anspruch 1, wobei, bei dem (a) Ausbilden der leitfähigen Struktur, die leitfähige Struktur auf der Oberfläche des Glases durch Verwendung einer leitfähigen Paste durch ein Druckverfahren ausgebildet wird.

3. Verfahren zur Herstellung eines geschwärzten Abschirmungsglases für elektromagnetische Interferenz nach Anspruch 2, wobei die leitfähige Paste hergestellt wird, indem ein Polymerbindemittel, eine Glasfritte und ein oder mehrere Metallpulver, ausgewählt aus der Gruppe, betstehend aus Silber, Kupfer, Gold und Aluminium, in einem organischen Lösemittel dispergiert werden.

4. Verfahren zur Herstellung eines geschwärzten Abschirmungsglases für elektromagnetische Interferenz nach Anspruch 2, wobei die leitfähige Paste 60 bis 80 Gew.-% Metallpulver, 5 bis 15 Gew.-% Glasfritte, 5 bis 20 Gew.-% Polymerbindemittel und 5 bis 20 Gew.-% organisches Lösemittel umfasst.

5. Verfahren zur Herstellung eines Abschirmungsglases für elektromagnetische Interferenz nach Anspruch 1, wobei das Brennen bei 400 bis 700 °C durchgeführt wird.

6. Verfahren zur Herstellung eines geschwärzten Abschirmungsglases für elektromagnetische Interferenz nach Anspruch 1, wobei die Lösung, die das reduktive Metall-Ion umfasst, ausgewählt ist aus der Gruppe, bestehend aus einer FeCl₂-Lösung, einer FeCl₃-Lösung, einer CuCl₂-Lösung und einer K₃Fe(CN)₆-Lösung.

7. Verfahren zur Herstellung eines geschwärzten Abschirmungsglases für elektromagnetische Interferenz nach Anspruch 1, wobei die Lösung, die das reduktive Metall-Ion umfasst, weiter ein Cl-Ion umfasst.

8. Abschirmungsglas für elektromagnetische Interferenz, umfassend:
ein Glas; und
eine leitfähige Struktur, die auf wenigstens einer Seite von einer Vorderseite und einer Rückseite des Glases ausgebildet ist,
wobei die leitfähige Struktur, die auf der Oberfläche des Glases ausgebildet ist, gebrannt ist und
wobei eine Oberfläche der leitfähigen Struktur durch Verwendung einer Lösung, die ein reduktives Metall-Ion umfasst, geschwärzt ist.

9. Abschirmungsglas für elektromagnetische Interferenz nach Anspruch 8, wobei die leitfähige Struktur auf der Oberfläche des Glases durch Verwendung einer leitfähigen Paste durch ein Druckverfahren ausgebildet ist.

10. Abschirmungsglas für elektromagnetische Interferenz nach Anspruch 9, wobei die leitfähige Paste hergestellt ist, indem ein Polymerbindemittel, eine Glasfritte und ein oder mehrere Metallpulver, ausgewählt aus der Gruppe, bestehend aus Silber, Kupfer, Gold und Aluminium, in einem organischen Lösemittel dispergiert werden.

11. Abschirmungsglas für elektromagnetische Interferenz nach Anspruch 9, wobei die leitfähige Paste 60 bis 80 Gew.-% Metallpulver, 5 bis 15 Gew.-% Glasfritte, 5 bis 20 Gew.-% Polymerbindemittel und 5 bis 20 Gew.-% organisches Lösemittel umfasst.

12. Abschirmungsglas für elektromagnetische Interferenz nach Anspruch 8, wobei das Glas mit der leitfähigen Struktur vor dem Schwärzen bei 400 bis 700 °C gebrannt ist.

13. Abschirmungsglas für elektromagnetische Interferenz nach Anspruch 8, wobei die Lösung, die das reduktive Metall-Ion umfasst, ausgewählt ist aus der Gruppe, bestehend aus einer FeCl₂-Lösung, einer FeCl₃-Lösung, einer CuCl₂-Lösung und einer K₃Fe(CN)₆-Lösung.

14. Abschirmungsglas für elektromagnetische Interferenz nach Anspruch 8, wobei die Lösung, die das reduktive Metall-Ion umfasst, weiter ein Cl-Ion umfasst.

15. PDP-Filter, umfassend:
das Abschirmungsglas für elektromagnetische Interferenz nach Anspruch 8; und
wenigstens einen Film, der an einer Vorderseite oder einer Rückseite des Abschirmungsglases für elektromagnetische Interferenz angebracht ist und ausgewählt ist aus der Gruppe, bestehend aus einem Antireflektionsfilm, einem Abschirmungsfilm für Strahlung im nahen Infrarotbereich und einem Farbkorrekturfilm.

16. PDP-Gerät, das den PDP-Filter nach Anspruch 15 umfasst.

## Revendications

1. Procédé de production d'un verre noirci faisant écran contre les interférences électromagnétiques, le procédé comprenant :
(a) la formation d'un motif conducteur sur au moins un côté d'un côté avant et d'un côté arrière du verre ;
(b) la cuisson du motif conducteur qui est formé sur la surface du verre ; et
(c) le noircissement d'une surface du motif conducteur en utilisant une solution comprenant un ion métallique réducteur.

2. Procédé de production d'un verre noirci faisant écran contre les interférences électromagnétiques selon la revendication 1, dans lequel dans ladite étape (a) de formation du motif conducteur, le motif conducteur est formé sur la surface du verre en utilisant une pâte conductrice au moyen d'un processus d'impression.

3. Procédé de production d'un verre noirci faisant écran contre les interférences électromagnétiques selon la revendication 2, dans lequel la pâte conductrice est préparée en dispersant un liant polymère, une fritte de verre et une ou plusieurs poudres métalliques sélectionnées dans le groupe consistant en argent, cuivre, or et aluminium dans un solvant organique.

4. Procédé de production d'un verre noirci faisant écran contre les interférences électromagnétiques selon la revendication 2, dans lequel la pâte conductrice comprend de 60 à 80% en poids de poudre métallique, de 5 à 15% en poids de fritte de verre, de 5 à 20% en poids de liant polymère, et de 5 à 20% en poids de solvant organique.

5. Procédé de production d'un verre faisant écran contre les interférences électromagnétiques selon la revendication 1, dans lequel la cuisson est effectuée entre 400 et 700 °C.

6. Procédé de production d'un verre noirci faisant écran contre les interférences électromagnétiques selon la revendication 1, dans lequel la solution comprenant l'ion métallique réducteur est sélectionnée dans le groupe consistant en une solution de FeCl₂, une solution de FeCl₃, une solution de CuCl₂, et une solution de F₃Fe(CN)₆.

7. Procédé de production d'un verre noirci faisant écran contre les interférences électromagnétiques selon la revendication 1, dans lequel la solution comprenant l'ion métallique réducteur comprend en outre un ion Cl.

8. Verre faisant écran contre les interférences électromagnétiques comprenant :
un verre ; et
un motif conducteur qui est formé sur au moins un côté d'un côté avant et d'un côté arrière du verre,
dans lequel le motif conducteur qui est formé sur la surface du verre est fixé, et
dans lequel une surface du motif conducteur est noircie en utilisant une solution comprenant un ion métallique réducteur.

9. Verre faisant écran contre les interférences électromagnétiques selon la revendication 8, dans lequel le motif conducteur est formé sur la surface du verre en utilisant une pâte conductrice au moyen d'un processus d'impression.

10. Verre faisant écran contre les interférences électromagnétiques selon la revendication 9, dans lequel la pâte conductrice est préparée en dispersant un liant polymère, une fritte de verre et une ou plusieurs poudres métalliques sélectionnées dans le groupe consistant en argent, cuivre, or et aluminium dans un solvant organique.

11. Verre faisant écran contre les interférences électromagnétiques selon la revendication 9, dans lequel la pâte conductrice comprend de 60 à 80% en poids de poudre métallique, de 5 à 15% en poids de fritte de verre, de 5 à 20% en poids de liant polymère, et de 5 à 20% en poids de solvant organique.

12. Verre faisant écran contre les interférences électromagnétiques selon la revendication 8, dans lequel le verre au motif conducteur est cuit entre 400 et 700 °C avant le noircissement.

13. Verre faisant écran contre les interférences électromagnétiques selon la revendication 8, dans lequel la solution comprenant l'ion métallique réducteur est sélectionnée dans le groupe consistant en une solution de FeCl₂, une solution de FeCl₃, une solution de CuCl₂, et une solution de F₃Fe(CN)₆.

14. Verre faisant écran contre les interférences électromagnétiques selon la revendication 8, dans lequel la solution comprenant l'ion métallique réducteur comprend en outre un ion Cl.

15. Filtre PDP comprenant:
le verre faisant écran contre les interférences électromagnétiques selon la revendication 8 ; et
au moins un film qui est fixé à un côté avant et un côté arrière du verre faisant écran contre les interférences électromagnétiques et qui est sélectionné dans le groupe consistant en un film antireflets, un film faisant écran contre les rayons de l'infrarouge proche, et un film de correction chromatique.

16. Dispositif PDP comprenant le filtre PDP selon la revendication 15.
